(19) Europäisches Patentamt
European Patent Office
Office européen des brevets

(11) Numéro de publication : **0 405 652 B1**

(12) # FASCICULE DE BREVET EUROPEEN

(45) Date de publication du fascicule du brevet : **14.09.94 Bulletin 94/37**

(51) Int. Cl.$^5$ : **H05K 3/42**, H05K 3/06, H05K 3/18

(21) Numéro de dépôt : **90201596.5**

(22) Date de dépôt : **19.06.90**

(54) **Procédé à cycle réduit pour la fabrication de circuits imprimés, et composition pour sa mise en oeuvre.**

(30) Priorité : **27.06.89 IT 6752089**

(43) Date de publication de la demande : **02.01.91 Bulletin 91/01**

(45) Mention de la délivrance du brevet : **14.09.94 Bulletin 94/37**

(84) Etats contractants désignés : **BE CH DE FR GB LI NL SE**

(56) Documents cités :
**EP-A- 0 249 425**
**EP-A- 0 261 424**
**US-A- 3 720 525**

(73) Titulaire : **ALFACHIMICI s.r.l.**
**Via F. Postiglione 8**
**I-10024 Moncalieri (Torino) (IT)**

(72) Inventeur : **Tomaiuolo, Francesco, Dr.**
**Strada del Pesco 9/c**
**I-10024 Moncaliere (Torino) (IT)**
Inventeur : **Cassia, Enrico**
**Via Mongrando 22**
**I-10153 Torino (IT)**

(74) Mandataire : **Patrito, Pier Franco, Dr. Ing.**
**Cabinet PATRITO BREVETTI**
**Via Don Minzoni 14**
**I-10121 Torino (IT)**

EP 0 405 652 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a trait à un procédé pour la fabrication de circuits imprimés comportant des trous passants qui les traversent, comprenant un pré-traitement de nettoyage et un traitement successif de métallisation, dans lequel le pré-traitement de nettoyage comprend un traitement éventuel dans un solvant organique, un traitement en une solution alcaline de permanganate et un traitement de réduction du permanganate, et le traitement de métallisation comprend un traitement de conditionnement des parois des trous passants, un traitement de mordançage des surfaces de cuivre, un traitement de pré-catalyse, un traitement de catalyse et un traitement de métallisation en un bain de cuivre chimique. L'invention a trait aussi à une composition pour la mise-en-oeuvre de ce procédé.

Dans les procédés pour la fabrication des circuits imprimés il est exigé de métalliser les trous passants pour les rendre conductifs et ainsi connecter électriquement entr'elles deux ou plusieurs couches imprimées du circuit. Le procédé de métallisation habituellement utilisé comporte la déposition anélectrique et autocatalytique de cuivre sur les parois des trous passants. Ce procédé est connu comme métallisation des trous passants (PTH = Plating-Through-Holes). Pour la déposition du cuivre sans intervention du courant électrique le procédé de métallisation PTH est normalement mis en oeuvre par six phases principales.

La première phase du procédé de métallisation PTH comporte un traitement par un produit dégraissant et conditionnant tensio-actif, dont la fonction est de dégraisser les surfaces de cuivre du laminé percé en éliminant les empreintes, les résidus huileux et similaires, à l'effet d'autoriser une attaque uniforme pendant le traitement successif de mordançage. En outre, ce bain a la fonction fondamentale de conditionner les parois des trous passants, c'est à dire de les préparer d'une façon appropriée à l'adsorption successive des particules catalytiques. Cette fonction donne la dénomination à la phase considérée, laquelle est nommée phase de conditionnement. Le conditionnement consiste à neutraliser les charges électriques négatives qui existent sur les parois des trous passants, lesquelles empêchent une adsorption uniforme des particules catalytiques, elles aussi chargées négativement.

La deuxième phase du procédé de métallisation PTH comporte un traitement de mordançage des surfaces de cuivre du laminé percé, ce traitement étant habituellement effectué dans un bain à base d'acides inorganiques, tels que l'acide solforique ou l'acide phosphorique, et d'eau oxigénée stabilisée. Comme alternative on employe souvent aussi des solutions à base de persulfates alcalins. Ce traitement a la fonction de rendre possible une fixation parfaite des dépôts succesifs de cuivre chimique et électrolytique.

La troisième phase du procédé de métallisation PTH comporte un traitement de pré-catalyse, qui est effectué habituellement en un bain à base de chlorure de sodium ou d'acide chlorhydrique dilué, qui a la fonction de protéger le bain successif de catalyse par rapport à une dilution abnormal par de l'eau ainsi qu'à des entraînements possibles de cuivre ou de produits tensio-actifs venant des bains précédents. Entre la troisième et la quatrième phase du procédé, en effet, aucun lavage intermédiaire n'est effectué.

La quatrième phase du procédé de métallisation PTH est constituée par un traitement de catalyse, effectué habituellement en un bain comportant une solution à base de palladium ou de chlorure d'étain, acide par acide chlorhydrique. Le bain de catalyse permet de déposer sur les parois des trous passants, préparées de façon appropriée par les traitements précédents, une couche mince et uniforme de métal catalytique, lequel est capable de promouvoir, pendant la phase successive de cuivrage chimique, la déposition du cuivre sans intervention du courant électrique.

La cinquième phase du procédé de métallisation PTH consiste en un traitement d'accélération, qui est effectué habituellement en une solution à base d'acides inorganiques tels que l'acide fluoborique, l'acide chlorhydrique, l'acide sulfurique et similaires. Le traitement d'accélération a la fonction de limiter l'entraînement de palladium dans le bain successif de cuivre chimique, parce qu'un entraînement excessif de palladium pourrait donner lieu à des phénomènes d'instabilité ou même à la décomposition totale du bain de cuivre chimique. Le traitement d'accélération a aussi la fonction d'activer la couche catalytique déposée sur les parois des trous passants, en enlevant le chlorure d'étain en excès et ainsi rendant très actif le palladium. Une couche catalytique plus active favorise la couverture totale des parois des trous passants pendant la phase successive de cuivrage chimique.

Enfin, la sixième phase du procédé de métallisation PTH comporte un cuivrage chimique. Dans cette phase le cuivre est déposé par voie chimique, sans intervention du courant électrique, sur les parois des trous passants, opportunément catalysées. Après que toute la couche catalytique à base de palladium a été couverte par du cuivre chimique, la réaction procède de façon auto-catalytique en déposant du cuivre sur le cuivre jusqu'à ce que l'épaisseur voulue a été atteinte. D'une façon générale, les bains de cuivre chimique sont constitués par une solution aqueuse d'un sel de cuivre, par un agent complexant du cuivre, par un agent réducteur et par un régulateur du pH. Ces bains travaillent habituellement à une valeur du pH compris entre 11 et 13. En plus de ces composants fondamentaux, les bains de cuivre chimique comportent une série de produits présents en des petites concentrations, tels que des agents stabiliseurs, tensio-actifs et autres. Après métallisation dans le bain de cuivre chimique, les circuits imprimés peuvent être assujettis à des traitements sécondaires ultérieurs, non considérés ici.

Dans la production des circuits imprimés feuilletés, avant le procédé de métallisation PTH on doit normalement procéder à un pré-traitement spécifique de nettoyage des parois des trous passants, connu comme "desmear". Ce traitement a le but d'éliminer des résidus éventuels déposés pendant le perçage sur les parois des trous passants, et en particulier sur les couches internes de cuivre. Si de tels résidus, constitués par de la résine époxyde fondue, n'étaient pas emportés avec soin, pendant la phase successive de métallisation on ne pourrait pas assurer la connexion électrique entre le dépôt de cuivre sur la paroi du trou et les couches internes de cuivre. Si l'on fait un traitement de nettoyage plus énergique des parois des trous passants, jusqu'à une profondeur d'attaque de la résine époxyde supérieure à 7,5-microns, ce traitement est nommé "etch-back". Dans ce cas on obtient une fixation sur trois points des dépôts de cuivre chimique et électrolytique sur les couches internes de cuivre, lequelles, après un traitement de etch-back, font saillie par rapport à la paroi du trou passant.

Pour effectuer le pré-traitement de nettoyage des parois des trous passants, normalement on fait usage de différents procédés qui se basent sur l'emploi d'acide chromique, d'acide sulfurique concentré, d'un permanganate en solution alcaline, ou bien on fait usage du procédé au plasma. Parmi tous ces procédés le plus exploité est le procédé à base de permanganate en solution alcaline. Ce procédé est généralement mis en oeuvre en trois phases.

La première phase du pré-traitement de nettoyage (laquelle en certains cas peut être omise) est constituée par un traitement en un bain à base d'un solvant organique, qui a la fonction d'amollir les surfaces de résine époxyde pour permettre d'obtenir, dans la phase successive d'attaque dans une solution alcaline à base de parmanganate, une surface époxyde micro-mordançée capable d'assurer successivement une adhésion maximale du dépôt de cuivre chimique. Ce bain peut contenir des mélanges de solvants organiques tels que le n-méthyl-2-pyrrholidon, la diméthylformamide, le butylcarbitol, le butylcellosolve, le butylcellosolve acétate et similaires, ou bien des solutions aqueuses alcalines de ces solvants organiques.

La deuxième phase du pré-traitement de nettoyage comporte le nettoyage proprement dit des parois des trous passants par un traitement en une solution alcaline à base de parmanganate. Cette solution est capable d'attaquer les résidus laissés par le perçage, par une action de type oxydatif, en les emportant des parois des trous passants et particulièrement des couches intérieures de cuivre. Après ce traitement les parois des trous passants se montrent exemptes de résidus du perçage et préparées de la meilleure façon pour recevoir le dépôt successif du cuivre chimique. Ces solutions sont normalement à base de permanganate de potassium ou de sodium et d'hydroxyde de sodium, et elles peuvent contenir, en plus d'un produit tensio-actif, un oxydant sécondaire tel que le persulfate de sodium ou l'hypochlorite de sodium. Cet oxydant sécondaire a la fonction de tenir en solution une concentration élevée de permanganate, au détriment du manganate qui en est le produit de réduction.

La troisième phase du pré-traitement de nettoyage des parois des trous passants comporte un traitement en un bain de neutralisation, qui remplit la fonction de réduire le permanganate retenu sur la surface des circuits imprimés et adsorbé sur les parois des trous passants. Dans cette phase le permanganate résiduel est réduit en ambiant acide à ion manganèse, lequel est soluble et donc peut être facilement éliminé. Ce bain de réduction est habituellement à base de bisulfite de sodium, de hydrazine, de hydroxylamine ou similaires, et il peut aussi contenir un agent tensio-actif.

Le pré-traitement de nettoyage des parois des trous passants avant métallisation par du cuivre chimique avait été créé comme un traitement spécifique pour les circuits imprimés feuilletés, c'est à dire comportant plusieurs couches, et il a été ensuite étendu aussi aux circuits imprimés à double face. En effet, par ce pré-traitement on peut obtenir une métallisation par du cuivre chimique qui présente une haute adhésion sur les parois des trous passants.

De plus, par ce pré-traitement le dépôt de cuivre chimique se montre compact et exempt de porosité, parce que la métallisation a lieu sur une surface cohérente, libre de résidus du perçage. Dans la phase successive de déposition du cuivre électrolytique, le dépôt qu'on obtient a donc une grande compacité et une considérable résistance aux traitements thermiques successifs. Par conséquent, les circuits imprimés fabriqués en faisant un pré-traitement de nettoyage des trous passants par du permagnanate avant métallisation par du cuivre chimique sont parfaitement soudables et ils montrent un pourcentage négligeable de trous passants désaccouplés ou manquant de l'alliage étain-plomb monté, ainsi que des caractéristiques optimales d'adhésion des dépôts sur les parois des trous passants.

Le pré-traitement de nettoyage des trous passants avant métallisation par du cuivre chimique comporte toutefois une augmentation considérable des frais de revient des circuits imprimés, en tant qu'aux frais des traitements proprement dits il faut ajouter les frais dérivant par le temps nécessaire pour charger et décharger

les circuits imprimés sur des cadres ou des paniers, une première fois pour le pré-traitement de nettoyage des trous passants et une deuxième fois pour le procédé de métallisation PTH. Ces frais adjontifs du pré-traitement de nettoyage sont toujours acceptés pour le traitement des circuits imprimés feuilletés, en vue de la valeur élevée de ces circuits, tandis que souvent les frais de ce pré-traitement ne sont pas acceptés dans la fabrication de circuits imprimés à double face, dont la valeur est moindre.

Une méthode pour réduire ces frais consiste dans l'intégration entre le procédé de métallisation et le pré-traitement de nettoyage, par la création d'une seule ligne pour le nettoyage et pour la métallisation des trous passants: c'est à dire que la ligne nécessaire pour le pré-traitement de nettoyage des trous passants est insérée directement avant la ligne de métallisation par du cuivre chimique. De cette façon la nécessité de charger et décharger deux fois les cadres ou les paniers est éliminée. Toutefois cette méthode comporte un investissement élevé de départ pour les appareillages; de plus, maintes fabriques de circuits imprimés ne disposent pas de l'espace physique nécessaire pour insérer la ligne de nettoyage directement avant la ligne de métallisation.

Dans le but de simplifier le procédé de fabrication des circuits imprimés on a proposé des cycles de nettoyage et de métallisation des trous passants, dans lesquels on a réduit le nombre de traitement nécessaires. Deux de ces cycles "courts" sont décrits dans le Brevet Européen No. 0.261.424. Ces cycles courts sont avantageux en tant qu'il réduisent le nombre total de traitements, mais en maints cas ils ne sont pas suffisants pour permettre d'effectuer un procédé de métallisation intégré avec un pré-traitement de nettoyage, parce que de nombreuses installations galvaniques existantes ne comportent pas un nombre suffisant de bacs. En effet, comme on l'a décrit ci-dessus, le procédé traditionnel de métallisation PTH comporte six traitements et le procédé de nettoyage des trous passants comporte trois traitements, de sorte que pour réaliser le procédé traditionnel d'ensemble de nettoyage et de métallisation des trous passants en une seule ligne il faut effectuer neuf traitements. Les cycles courts décrits dans le Brevet Européen No. 0.261.424 demandent encore sept traitements. Par conséquence ils ne peuvent pas être directement exploités dans les lignes de métallisation traditionnelles qui sont disposées pour effectuer seulement six traitements, plus les lavages intermédiaires correspondants. Si l'on veut utiliser les nouveaux cycles il est donc en tous cas nécessaire de porter des modifications substantielles à la structure des lignes de métallisation traditionnelles, en introduisant des bacs nouveaux et en modifiant le système mécanisé de transport des cadres ou paniers.

Il serait donc extrèmement intéressant de réaliser un procédé intégré de nettoyage et de métallisation des trous passants qui pourrait être effectué par six traitements principaux seulement. Dans un tel cas les lignes de métallisation traditionnelles, dessinées pour six traitements seulement, pourraient être utilisées telles quelles, sans aucune modification de structure. En vue de cette situation, la présente invention a le but de réaliser un nouveau cycle intégré pour le nettoyage et la métallisation des trous passants des circuits imprimés, qui demande un nombre (six ou moins) de traitements, extrèmement réduit par rapport à un cycle traditionnel.

La présente invention a pour objet un procédé pour la fabrication de circuits imprimés comportant des trous passants, comprenant un pré-traitement de nettoyage et un traitement successif de métallisation, dans lequel le pré-traitement de nettoyage comprend un traitement éventuel dans un solvant organique, un traitement en une solution alcaline de permanganate et un traitement de réduction du permanganate, et le traitement de métallisation comprend un traitement de conditionnement des parois des trous passants, un traitement de mordançage des surfaces de cuivre, un traitement de pré-catalyse, un traitement de catalyse et un traitement de métallisation en un bain de cuivre chimique, caractérisé en ce que trois traitements, à savoir la réduction du permanganate, le conditionnement des parois des trous passants et le mordançage des surfaces de cuivre, sont effectués par une seule opération, le traitement de conditionnement des parois des trous passants étant effectué par des polymères solubles dans l'eau, non tensio-actifs, faisant partie du groupe des polyélectrolytes cationiques, présents à une concentration comprise entre 0,001 et 100 g/l.

De plus, la phase d'accélération peut être éliminée en faisant usage d'un bain de cuivre chimique approprié, plus particulièrement un bain qui travaille à une valeur de pH très élevé (supérieur à 13), lequel rend non nécessaire ladite phase d'accélération. Le cycle réduit, objet de la présente invention, autorise donc la réalisation d'un procédé intégré de nettoyage et de métallisation des trous passants qui demande seulement six traitements, au lieu que neuf comme il était nécessaire jusqu'ici selon les procédés traditionnels. De plus, comme on l'a déjà dit, en certains cas le traitement dans un solvant organique peut être omis. Dans ces cas, le nombre des phases principales est ultérieurement réduit de six à cinq.

Une comparaison parmi des différents cycles de nettoyage et de métallisation est exposé ci de suite, en négligeant les lavages intermédiaires:

| PROCEDE TRADITIONNEL | PROCEDE SELON LE BREVET EP-0.261.424 | PROCEDE SUIVANT L'INVENTION |
|---|---|---|
| 1 SOLVANT | 1 SOLVANT | 1 SOLVANT |
| 2 PERMANGANATE | 2 PERMANGANATE | 2 PERMANGANATE |
| 3 REDUCTION | 3 REDUCTION ET CONDITIONNEMENT | 3 REDUCTION, CONDITIONNEMENT ET MORDANCAGE |
| 4 CONDITIONNEMENT | | |
| 5 MORDANCAGE | 4 MORDANCAGE | |
| 6 PRE-CATALYSE | 5 PRE-CATALYSE | 4 PRE-CATALYSE |
| 7 CATALYSE | 6 CATALYSE | 5 CATALYSE |
| 8 ACCELERATION | | |
| 9 CUIVRAGE CHIMIQUE | 7 CUIVRAGE CHIMIQUE | 6 CUIVRAGE CHIMIQUE |

Dans le cycle objet de la présente invention, du fait qu'on a réduit le nombre des traitements, on réduit aussi de façon correspondante le nombre des lavages, et donc la quantité d'eau qui doit être consommée pour mentre en oeuvre le procédé.

De son côté, la composition objet de l'invention, pour la mise en oeuvre de trois traitements par une seule opération dans le cadre d'un procédé intégré de nettoyage et de métallisation pour la fabrication de circuits imprimés, est principalement caractérisée en ce qu'elle contient un acide, de l'eau oxygénée, un stabiliseur pour l'eau oxygénée et un produit conditionneur non tensio-actif faisant partie du groupe des polyélectrolytes cationiques.

Comme on l'a dit, le procédé objet de la présente invention est basé sur l'utilisation d'une nouvelle composition qui autorise la réalisation de trois traitements par une seule opération, et cela, aussi du fait de l'élimination de la phase d'accélération, donne la possibilité de réduire à six (ou moins) le nombre total des traitements nécessaires pour effectuer de manière intégrée le nettoyage et la métallisation des trous passants des circuits intégrés.

Ce procédé peut être donc mis en oeuvre dans une ligne de métallisation traditionnelle, sans demander aucune modification substantielle de la structure des appareillages.

Ledit procédé permet de traiter indifféremment soit les circuits imprimés à double face, soit les circuits feuilletés, en assurant une qualité finale élevée.

Le nouveau bain objet de la présente invention, qui est capable d'effectuer trois traitements en une phase seulement, comporte avant tout deux composants de base qui sont un acide, de préférence inorganique, tel que l'acide sulfurique ou l'acide phosphorique, et l'eau oxygénée. L'eau oxygénée travaille, dans cette solution acide, soit comme un agent réducteur par rapport à un oxidant fort comme le permanganate, soit comme un agent oxidant par rapport au cuivre.

Les circuits imprimés, après le traitement dans la solution alcaline à base de permanganate par lequel on réalise le nettoyage des parois des trous passants, sont lavés en eau et ensuite traités dans ce nouveau bain à action triple. Pendant ce traitement, en un première phase on a la réduction totale du permanganate adsorbé soit sur les surfaces de cuivre, soit sur les parois des trous passants. La réaction décrivant cette première phase est la suivante :

$$2\,MnO_4^- + 5\,H_2O_2 + 6\,H^+ \rightarrow 2\,Mn^{++} + 5\,O_2 + 8\,H_2O$$

Dans le bain on peut observer la génération d'un gaz, dû à la formation d'oxygène. Lors que la réaction précédente est complétée survient l'attaque et donc le mordançage des surfaces de cuivre. La réaction décrivant cette phase est la suivante:

$$Cu + H_2O_2 + 2\,H^+ \rightarrow Cu^{2+} + 2\,H_2O_2$$

En plus de l'eau oxygénée et de la source d'ions hydrogène, la composition de ce nouveau bain comporte un troisième composant constitué par l'agent stabiliseur de l'eau oxygénée, lequel déroule la fonction importante de réduire au minimum la décomposition de l'eau oxygénée, soit pendant la phase de travail, soit pendant les

arrêts de la production. En effet, si la décomposition de l'eau oxygénée était excessive, et donc sa concentration dans le bain devenait insuffisante, on aurait une compromission soit du pouvoir réducteur par rapport au permanganate, qui porterait ensuite à une métallisation pauvre des parois des trous passants, soit du pouvoir de mordançage des surfaces de cuivre, en posant des problèmes d'adhésion faible du dépôt successif de cuivre chimique sur les surfaces de cuivre du laminé de base.

Pour réduire au minimum la décomposition de l'eau oxygénée on peut faire usage de stabiliseurs organiques tels que l'acide phénolsulfonique, l'acide crésolsulfonique, le phénol, le 1,3-butanediol, le 1-butanol, l'acide toluensulfonique, l'acide para-hydroxybenzoïque, l'acide glycolique, le butanon-2, et autres produits ayant un comportement similaire.

Un quatrième composant de ce nouveau bain, objet de la présente invention, est constitué par le conditionneur non tensio-actif. Le conditionneur déroule la fonction essentielle de préparer les parois des trous passants pour la phase successive de catalyse. Sans un conditionnement approprié les parois des trous passants ne peuvent pas subir une catalyse uniforme, soit sur la résine époxyde, soit sur les fibres de verre, et donc une métallisation totale par du cuivre chimique.

Dans les procédés traditionnels de métallisation l'action de conditionnement est habituellement effectuée par des produits tensio-actifs cationiques à base de sels d'ammonium quaternaires, ou de produits similaires.

Toutefois, dans le bain suivant la présente invention il ne serait pas possible d'insérer aucun genre de produit tensio-actif, qui interfèrerait gravement avec l'action de mordançage déroulée contemporairement par ce bain, et cela soit en ralentissant d'une façon draconienne l'attaque du cuivre, soit en laissant un film organique sur les surfaces de cuivre. Comme conséquence d'une telle interférence l'adhésion du dépôt de cuivre chimique sur les surfaces de cuivre du laminé de base serait compromise.

Pour éviter ce grave inconvénient il a été nécessaire de rechercher des nouveaux agents conditionneurs qui devaient être de nature cationique mais ne devaient pas être tensio-actifs.

Les nouveaux agents conditionneurs non tensio-actifs employés suivant la présente invention sont constitués par des solution aqueuses de polymères hydrosolubles faisant partie du groupe des polyélectrolytes cationiques, et de manière plus spécifique ils sont des polymères d'un esther de l'acide métacrylique.

La formule chimique générale décrivant ce groupe de polymères est la suivante:

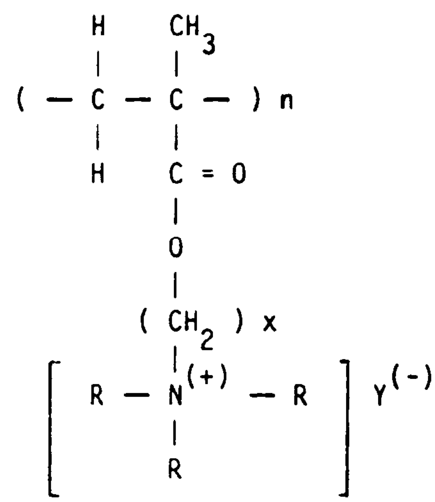

où : x = 1 à 5 ; R = H O $CH_3$ ; Y = $Cl^-$, $Br^-$, $SO_4^=$ , $CH_3OSO_3^-$ etc.

Le poids moléculaire de ces nouveaux agents conditionneurs est compris entre 100.000 et 5.000.000. Ces polyélectrolytes cationiques sont capables de conditionner les parois des trous passants des circuits imprimés du fait qu'ils favorisent une adsorption uniforme des particules catalytiques, qui sont chargées négativement.

Comme on l'a dit, la réduction du nombre des traitements nécessaires pour effectuer de manière intégrée le nettoyage et la métallisation des trous passants des circuits imprimés est obtenue, outre que par l'utilisation du bain décrit ci-dessus, qui autorise la réalisation de trois traitements par une seule opération, aussi par l'élimination de la phase d'accélération.

Dans le cycle objet de cette invention, la phase d'accélération peut être considérée comme optionnelle, mais seulement si l'on fait usage d'un bain de cuivre chimique ayant des caractéristiques appropriées. Selon un aspect de la présente invention, la modification introduite à cet effet dans la composition du bain de cuivre chimique consiste à augmenter le pH auquel le bain de cuivre chimique travaille. Si l'on fait usage d'un bain de cuivre chimique traditionnel, travaillant à un pH également traditionnel, l'élimination de la phase d'accélération comporte une grave réduction de l'adhésion du dépôt de cuivre chimique sur les surfaces de cuivre du laminé de base. Au contraire, si l'on fait usage d'un bain de cuivre chimique travaillant à un pH supérieur à celui qui est traditionnel, l'adhésion du cuivre chimique sur le laminé de base se montre optimale même si la phase d'accélération est omise.

Un aspect particulier de la présente invention consiste en ce que le pH auquel on doit travailler n'est pas constant pour tous les bains de cuivre chimique, mais il est une fonction de la composition du bain et, en particulier, du type d'agent complexant du cuivre dont on fait usage. En effet, si l'on emploie comme agent complexant du cuivre la N,N,N',N' tétra(2-hydroxypropyle)éthylènediamine, laquelle travaille habituellement avec des bons résultats de métallisation à une valeur du pH comprise entre 12 et 13, il est suffisant augmenter le pH jusqu'à des valeurs supérieures à 13 pour rendre non nécessaire la phase d'accélération. Si, au contraire, on fait usage comme agent complexant du cuivre de l'acide éthylène-diamine-tétra-acétique, lequel travaille habituellement à une valeur du pH comprise entre 12 et 13, il est nécessaire d'augmenter ultérieurement le pH jusqu'à des valeurs supérieurs à 13,5. Il s'agit de valeurs décisément anormales pour un bain de cuivre chimique.

La tendance actuelle est d'utiliser de plus en plus l'acide éthylène-diamine-tétra-acétique comme agent complexant du cuivre dans les bains de cuivre chimique, parce que cet agent complexant est plus écologique. En effet il peut être précipité des bains de cuivre chimique épuisés, et partant il peut être recyclé. Dans le procédé objet de la présente invention on peut faire usage indifféremment de bains de cuivre chimique formulés avec les deux types d'agent complexant indiqués, en corrigeant d'une façon appropriée le pH de travail, et les bains de cuivre chimique qui font usage de l'acide éthylène-diamine-tétra-acétique sont à préférer seulement pour la susdite raison écologique.

L'objet de la présente invention sera décrit avec plus de détail dans la suite par l'aide de certaines exemples.

EXEMPLE 1.

Un laminé de verre et résine époxyde avec du cuivre sur les deux faces, du type dit FR-4, a été coupé et percé d'une façon appropriée. On a procédé au nettoyage et à la métallisation des trous passants de ce circuit par l'utilisation du suivant procédé en six phases:

1) Traitement en un solvant organique nommé CUPROLITE MLX (produit par Alfachimici S.p.A.), pour 5 minutes à 30°C, suivi par un double lavage en eau.

2) Traitement en un bain à base de permanganate alcaline, nommé EPOXYMOD MLX (200) (produit par Alfachimici S.p.A.), pour 10 minutes à 80°C. Ce bain travaille avec un contenu de permanganate de potassium de 200 g/l et de hydroxyde de sodium de 20 g/l. Ce traitement est suivi par un double lavage en eau.

3) Traitement pour 5 minutes à 35°C dans un bain lequel, suivant la présente invention, déroule la fonction triple de réducteur, de conditionneur et de mordançeur, comprenant:

| | | |
|---|---|---|
| Acide sulfurique | : | 150 g/l |
| Eau oxygénée | : | 20 g/l |
| Acide phénolsulfonique | : | 10 ml/l |
| Polymère à base d'un esther de l'acide méthacrylique | : | 0,5 g/l |
| Eau déionisée jusqu'à | : | 1 litre. |

Ce traitement est suivi par un double lavage en eau courante.

4) Traitement, pour 1 minute à 25°C, en une solution de pré-catalyse nommée UNIPHASE MLX A (produite par Alfachimici S.p.A.), comportant 200 g/l de chlorure de sodium et 20 ml/l d'acide chlorhydrique 37%. Passage à la phase de catalyse sans lavage intermédiaire.

5) Traitement, pour 5 minutes à 30°C, en une solution de catalyse nommée UNIPHASE MLX A+B (produite par Alfachimici S.p.A.). Cette solution comporte, en plus des composants de la solution précédente, 0,15 g/l de palladium et 15 g/l de chlorure d'étain. Ce traitement est suivi par un double lavage en eau courante.

6) Traitement, pour 30 minutes à 38°C, en un bain de cuivre chimique nommé CUPROTHICK '84 (produit par Alfachimici S.p.A.), lequel travaille avec les paramètres suivants:

| | | |
|---|---|---|
| Cuivre (sous la forme de chlorure de cuivre) | : | 4 g/l |
| Aldéhyde formique | : | 5 g/l |
| N,N,N',N' tétra(2-hydroxypropyle)éthylènediamine | : | 0,15 M |
| pH | : | 13,2 |

Le circuit métallisé suivant le procédé décrit ci-dessus a été testé pour évaluer la couverture de la paroi du trou passant par du cuivre chimique, ainsi que l'adhésion entre le dépôt de cuivre chimique et le cuivre du laminé de base. La couverture de la paroi du trou passant par du cuivre chimique a été évaluée par des observations au microscope à scansion électronique (SEM) et par des observations, avec l'aide du stéréomicroscope, de la lumière transmise à travers les parois des trous passants (back-light test). Ces observations ont permis d'évaluer une couverture au 100% des parois des trous passants par du cuivre chimique.

L'adhésion du dépôt de cuivre chimique a été évaluée par trois procédés différents. Le premier procédé consiste dans le test habituel d'arrachement d'un ruban adhésif bien appliqué sur la surface du circuit, métallisée par du cuivre chimique. Par ce test on a remarqué que le 100% du dépôt de cuivre chimique est demeuré adhérent au laminé de base, et qu'il n'y avait aucune trace du dépôt de cuivre chimique sur le ruban adhésif. Pour effectuer des autres preuves d'adhésion on a déposé, sur la surface de cuivre chimique du circuit imprimé, du cuivre électrolytique jusqu'à une épaisseur totale de 25 microns. Sur une partie de ce circuit on a procédé ensuite à une preuve de sollicitation thermique suivant la norme MIL P 55110 D, laquelle prévoit la flottaison sur de l'alliage étain-plomb à 288 °C pour 10 secondes, suivie par un refroidissement à l'air. Pour évaluer l'adhésion après ce test on a effectué des microsections métallographiques en plusieurs points du circuit, et on a constaté qu'il n'y avait trace de délamination à l'interface entre le cuivre chimique et le cuivre du laminé de base. La partie restante du circuit, non soumise à la sollicitation thermique, a été pratiquement détruite en arrachant mécaniquement par une pince, en plusieurs points, les dépôts de la surface du laminé de verre et de résine époxyde. Par l'effectuation de cette preuve extrèmement sévère on n'a relevé aucune région dans laquelle le dépôt de cuivre chimique se serait détaché du cuivre de base. Cela confirme l'adhésion parfaite qu'on obtient pas le procédé indiqué ci-dessus.

EXEMPLE 2 (comparatif)

Le même procédé suivant l'Exemple 1 a été répété en employant, pour réaliser la phase 3, un bain dont la composition ne comprenait pas le conditionneur non tensio-actif constitué par un esther de l'acide méthacrylique. Comme il était prévu, dans ce cas on a atteint seulement une couverture très partielle (70%) des parois des trous passants par du cuivre chimique, tandis que l'adhésion du dépôt de cuivre chimique sur les surfaces de cuivre du laminé de base demeurait parfaite.

EXEMPLE 3 (comparatif)

Le même procédé suivant l'Exemple 1 a été répété en employant, pour réaliser la phase 3, un bain dans lequel la fonction de conditionneur était déroulée par un agent tensio-actif cationique traditionnel à base d'un sel d'ammonium quaternaire, le produit nommé Lankrostat QAT (mis en commerce par LANKRO Chemicals Limited). Dans ce cas on a atteint une couverture totale (100%) des parois des trous passants par du cuivre chimique, tandis que l'adhésion du dépôt de cuivre chimique sur les surfaces de cuivre du laminé de base, contrôlée suivant les méthodes expliquées dans l'Exemple 1, s'est démontrée insuffisante, avec des délaminations considérables entre les deux couches de cuivre.

EXEMPLE 4 (comparatif)

Le même procédé suivant l'Exemple 1 a été répété en employant, pour réaliser la phase 6, le même bain de cuivre chimique suivant l'Exemple 1, nommé CUPROTHICK '84 (produit par Alfachimici S.p.A.), mais à une valeur du pH de 12,7. Dans ce cas on a atteint une couverture totale (100%) des parois des trous passants par du cuivre chimique, tandis que l'adhésion du dépôt de cuivre chimique sur les surfaces de cuivre du laminé de base s'est démontrée insuffisante, avec des délaminations considérables entre les deux couches de cuivre.

EXEMPLE 5

Le même procédé suivant l'Exemple 1 a été répété en employant, pour réaliser la phase 6, un bain de cuivre chimique ayant la suivante composition de base:

| | | |
|---|---|---|
| Cuivre (sous la forme de chlorure de cuivre) | : | 3 g/l |
| Aldéhyde formique | : | 3,5 g/l |
| Acide éthylènediamine-tétra-acétique, sel sodique | : | 0,18 M |
| pH | : | 13,6 |

Le résultats atteints dans ce cas sont exactement les mêmes suivant l'Exemple 1, c'est à dire que la couverture par du cuivre chimique des parois des trous passants était totale (100%) et que l'adhésion du dépôt de cuivre chimique sur les surfaces de cuivre du laminé de base s'est démontrée parfaite.

EXEMPLE 6 (comparatif)

Le même procédé suivant l'Exemple 1 a été répété en employant, pour réaliser la phase 6, le même bain de cuivre chimique suivant l'Exemple 5, mais à une valeur du pH de 13,1. Dans ce cas on a encore atteint une couverture totale (100%) des parois des trous passants par du cuivre chimique mais, au contraire que suivant l'Exemple 5, l'adhésion du dépôt de cuivre chimique sur les surfaces de cuivre du laminé de base s'est démontrée insuffisante, avec des délaminations considérables entre les deux couches de cuivre.

EXEMPLE 7

Le même procédé suivant l'Exemple 1 a été répété en employant, pour réaliser la phase 6, un bain de cuivre chimique ayant la suivante composition de base:

| | | |
|---|---|---|
| Cuivre (sous la forme de sulfate de cuivre) | : | 4 g/l |
| Aldéhyde formique | : | 4 g/l |
| N,N,N',N' tétra(2-hydroxypropyle)éthylènediamine | : | 0,15 M |
| pH | : | 13,3 |

Aussi dans ce cas, où l'on a utilisé un bain de cuivre chimique dans lequel le cuivre est sous la forme de sulfate de cuivre, les résultats atteints, soit de couverture des parois des trous passants, soit d'adhésion du dépôt de cuivre chimique sur la surface du cuivre de base, ont été exactement les mêmes suivant l'Exemple 1, à savoir couverture totale (100%) et adhésion parfaite.

EXEMPLE 8

Le même procédé suivant l'Exemple 1 a été appliqué à un autre laminé de verre et de résine époxyde du type FR-4, coupé et percé d'une façon appropriée. Après le nettoyage et la métallisation des trous passants par du cuivre chimique, ce circuit à double face a été imprimé et ensuite complété suivant la technique usuelle. Le circuit fini a été ensuite soudé par vagues de flux, et on a vérifié que la soudabilité de ce circuit était parfaite. En effet on n'a pas remarqué des trous passants désaccouplés ou des trous passants manquant de l'alliage étain-plomb monté. En faisant des microsections métallographiques en plusieurs points, on n'a remarqué aucun détachement du dépôt de la parois des trous passants, dont la résine époxyde était micromordancée uniformément.

EXEMPLE 9

Le même procédé suivant l'Exemple 8 a été répété sur un circuit imprimé feuilleté. Aussi dans ce cas on a atteint une soudabilité parfaite. De plus, l'examen des microsections métallographiques a mis en évidence

un ancrage parfait des dépôts de cuivre chimique et électrolytique sur les couches intérieures de cuivre présentes sur les parois des trous passants. Ce circuit feuilleté, après avoir été soudé par vagues de flux, a été soumis à un test de sollicitation thermique suivant la règle MIL P 55110 D. Dans ces conditions aussi les microsections métallographiques ont confirmé l'adhésion parfaite des dépôts de cuivre chimique et électrolytique sur les couches intérieures de cuivre.

EXEMPLE 10

Un laminé de verre et de résine époxyde couvert par du cuivre sur les deux faces, du type FR 4, a été coupé et percé de façon appropriée. On a ensuite procédé au nettoyage et à la métallisation des trous passants de ce circuit en employant le suivant procédé en six phases:

1) Traitement pour 10 minutes à 70°C en un bain nommé CUPROLITE MLX 88 (produit par Alfachimici S.p.A.), suivi par un double lavage en eau. Le bain employé est à base d'une solution alcaline d'un glycoléther.

2) Traitement pour 10 minutes à 80°C en un bain nommé EPOXYMOD MLX (60) (produit par Alfachimici S.p.A.), qui travaille avec un contenu de permanganate de potassium de 60 g/l et de hydroxyde de sodium de 40 g/l. Ce traitement est suivi par un double lavage en eau. Le premier de ces deux lavages peut être éventuellement constitué par un lavage statique en une solution diluée contenant de l'acide sulfurique et de l'eau oxygénée, dans le but d'effectuer une pré-réduction du permanganate et ainsi de prolonger la durée utile du bain successif réducteur, conditionneur et mordanceur.

3) Traitement pour 5 minutes à 35°C dans un bain suivant la présente invention, capable de dérouler la fonction triple de réducteur, de conditionneur et de mordançeur, comprenant:

| | | | |
|---|---|---|---|
| Acide phosphorique | : | 200 | g/l |
| Eau oxygénée | : | 40 | g/l |
| Acide para-hydroxybenzoïque | : | 0,5 | g/l |
| Polymère à base d'un esther de l'acide méthacrylique | : | 2 | g/l |
| Eau déionisée jusqu'à | : | 1 | litre. |

Ce traitement est suivi par un double lavage en eau courante.

4) Traitement, pour 1 minute à 25°C, en une solution de pré-catalyse nommée UNIPHASE MLX A (produite par Alfachimici S.p.A.).

5) Traitement, pour 5 minutes à 30°C, en une solution de catalyse nommée UNIPHASE MLX A+B (produite par Alfachimici S.p.A.). Ce traitement est suivi par un double lavage en eau courante.

6) Traitement, pour 30 minutes à 38°C, en un bain de cuivre chimique nommé CUPROTHICK '84 (produit par Alfachimici S.p.A.), lequel travaille avec une valeur du pH de 13,2.

Le circuit métallisé suivant le procédé décrit ci-dessus a été testé par la méthode suivant l'Exemple 1. Par ce test est résulté que la couverture par du cuivre chimique des parois des trous passants était totale (100%) dans ce cas aussi, et que l'adhésion du dépôt de cuivre chimique sur les surfaces de cuivre du laminé de base était parfaite.

On constate donc que le procédé suivant l'invention, mis en oeuvre par l'emploi, dans une de ses phases, d'un bain montrant une composition particulière, elle-aussi objet de l'invention, permet d'effectuer, par six (ou moins) traitements principaux seulement, la fabrication de circuits imprimés pleinement satisfaisants.

Bien entendu, des modifications et tout remplacement par des équivalents techniques peuvent être portés à ce qui a été décrit, dans le cadre des revendications.

## Revendications

1. Procédé pour la fabrication de circuits imprimés comportant des trous passants, comprenant un pré-traitement de nettoyage et un traitement successif de métallisation, dans lequel le pré-traitement de nettoyage comprend un traitement éventuel dans un solvant organique, un traitement en une solution alcaline de permanganate et un traitement de réduction du permanganate, et le traitement de métallisation comprend un traitement de conditionnement des parois des trous passants, un traitement de mordançage

des surfaces de cuivre, un traitement de pré-catalyse, un traitement de catalyse et un traitement de métallisation en un bain de cuivre chimique, caractérisé en ce que trois traitements, à savoir la réduction du permanganate, le conditionnement des parois des trous passants et le mordançage des surfaces de cuivre, sont effectués par une seule opération, le traitement de conditionnement des parois des trous passants étant effectué par des polymères solubles dans l'eau, non tensio-actifs, faisant partie du groupe des polyélectrolytes cationiques, présents à une concentration comprie entre 0,001 et 100 g/l.

**2.** Procédé suivant la revendication 1, caractérisé en ce que le traitement de réduction du permanganate est effectué par de l'eau oxygénée en ambiant acide, laquelle déroule aussi une action d'oxydation par rapport aux surfaces de cuivre.

**3.** Procédé suivant la revendication 1, caractérisé en ce que le traitement de métallisation est effectué en un bain de cuivre chimique dans lequel la source de ions cuivriques est constituée par un sel faisant partie du groupe comprenant le chlorure de cuivre, le sulfate de cuivre, le fluoborate de cuivre et le nitrate de cuivre.

**4.** Procédé suivant la revendication 3, caractérisé en ce que le traitement de métallisation est effectué dans un bain de cuivre chimique dans lequel l'agent complexant du cuivre est constitué par N,N,N′,N′ tétra(2-hydroxypropyle)éthylènediamine ou par ses dérivés.

**5.** Procédé suivant la revendication 4, caractérisé en ce que le traitement de métallisation est effectué dans un bain de cuivre chimique qui travaille à une valeur du pH supérieur à 13.

**6.** Procédé suivant la revendication 3, caractérisé en ce que le traitement de métallisation est effectué dans un bain de cuivre chimique dans lequel l'agent complexant du cuivre est constitué par des sels de l'acide éthylénediamine-tétra-acétique ou de ses dérivés.

**7.** Procédé suivant la revendication 6, caractérisé en ce que le traitement de métallisation est efectué dans un bain de cuivre chimique qui travaille à une valeur du pH supérieur à 13,5.

**8.** Procédé suivant la revendication 1, caractérisé en ce que le traitement dans un solvant organique est effectué en un solvant organique soluble dans l'eau, faisant partie du groupe comprenant N-méthyl-2-pyrrholidon et diméthylformamide.

**9.** Procédé suivant la revendication 1, caractérisé en ce que le traitement dans un solvant organique est effectué dans une solution aqueuse en ambiant alcaline d'au moins un solvant organique soluble dans l'eau faisant partie du groupe comprenant propyle-glycole-monométhyléther et dipropyle-glycole-monométhyléther.

**10.** Procédé suivant la revendication 1, caractérisé en ce que le traitement dansune solution alcaline de permanganate est effectué en une solution contenant du permanganate de sodium ou du permanganate de potassium.

**11.** Procédé suivant la revendication 10, caractérisé en ce que le traitement dans une solution alcaline de permanganate est effectuée en une solution contenant permanganate de potassium à une concentration comprise entre 150 et 250 g/l et hydroxyde de sodium à une concentration comprise entre 15 et 30 g/l.

**12.** Procédé suivant la revendication 10, caractérisé en ce que le traitement dans une solution de permanganate est effectuée en une solution contenant permanganate de potassium à une concentration comprise entre 40 et 80 g/l et hydroxyde de sodium à une concentration comprise entre 30 et 50 g/l.

**13.** Procédé suivant la revendication 1, caractérisé en ce que le traitement de pré-catalyse est effectué dans une solution contenant 200 g/l de chlorure de sodium et 20 ml/l d'acide chlorhydrique au 37%.

**14.** Procédé suivant la revendication 1, caractérisé en ce que le traitement de pré-catalyse est effectué dans une solution contenant 300 ml/l d'acide chlorhydrique au 37%.

**15.** Procédé suivant la revendication 1, caractérisé en ce que le traitement de catalyse est effectué dans une solution acide à base de palladium et de chlorure d'étain, avec un contenu de palladium compris entre 0,05 et 0,20 g/l et un contenu de chlorure d'étain compris entre 5 et 20 g/l.

16. Procédé suivant la revendication 1, caractérisé en ce que le traitement de catalyse est effectué dans une solution alcaline à base de palladium sous forme ionique.

17. Procédé suivant la revendication 1, caractérisé en ce que le traitement de catalyse est effectué dans une solution à base de cuivre ou à base de cuivre et de palladium.

18. Procédé suivant la revendication 1, caractérisé en ce que le traitement de catalyse est effectué dans une solution à base d'un métal noble tel que le platine, l'or ou l'argent.

19. Procédé suivant la revendication 1, caractérisé par son emploi dans la fabrication de circuits imprimés à double face (rigides, flexibles ou flexi-rigides).

20. Procédé suivant la revendication 1, caractérisé par son emploi dans la fabrication de circuits imprimés feuilletés (rigides, flexibles ou flexi-rigides).

21. Procédé suivant la revendication 1, caractérisé en ce que le traitement de nettoyage et de métallisation des trous passants des circuits imprimés (à double face ou feuilletés) est effectué en une ligne de métallisation traditionnelle, sans aucune modification substantielle de sa structure.

22. Composition pour la mise en oeuvre de trois traitements par une seule opération, dans le cadre d'un procédé intégré de nettoyage et de métallisation pour la fabrication de circuits imprimés, caractérisée en ce qu'elle contient un acide, de l'eau oxygénée, un stabiliseur pour l'eau oxygénée et un produit conditionneur non tensio-actif faisant partie du groupe des polyélectrolytes cationiques, présent à une concentration comprise entre 0,001 et 100 g/l, en solution aqueuse.

23. Composition suivant la revendication 22, caractérisée en ce que ledit produit conditionneur non tensio-actif est constitué par au moins un polymère cationique modifié de l'acide achrylique.

24. Composition suivant la revendication 22, caractérisée en ce que ledit produit conditionneur non tensio-actif est constitué par un polymère à base d'un esther de l'acide métachrylique.

25. Composition suivant la revendication 24, caractérisée en ce que le polymère à base d'un esther de l'acide métachrylique est présent à une concentration comprise entre 0,001 et 100 g/l et de préférence comprise entre 0,01 et 5 g/l.

26. Composition suivant la revendication 22, caractérisée en ce que l'eau oxygénée est présente à une concentration comprise entre 1 et 100 g/l et de préférence comprise entre 10 et 40 g/l.

27. Composition suivant la revendication 22, caractérisée en ce que ledit acide est un acide inorganique.

28. Composition suivant la revendication 27, caractérisée en ce que ledit acide inorganique est de l'acide sulfurique.

29. Composition suivant la revendication 28, caractérisée en ce que l'acide sulfurique est présent à une concentration comprise entre 50 et 200 g/l.

30. Composition suivant la revendication 27, caractérisée en ce que ledit acide inorganique est de l'acide phosphorique.

31. Composition suivant la revendication 30, caractérisée en ce que l'acide phosphorique est présent à une concentration comprise entre 100 et 300 g/l.

32. Composition suivant la revendication 22, caractérisée en ce qu'elle contient un stabiliseur organique de l'eau oxygénée.

33. Composition suivant la revendication 32, caractérisée en ce que ledit stabiliseur organique est constitué par de l'acide para-hydroxybenzoïque.

34. Composition suivant la revendication 33, caractérisée en ce que l'acide para-hydroxybenzoïque est présent à une concentration comprise entre 0,01 et 100 g/l et de préférence comprise entre 0,05 et 0,5 g/l.

## Patentansprüche

1. Verfahren zur Herstellung von Durchgangsbohrungen aufweisenden gedruckten Schaltungen, bestehend aus einer Reinigungsvorbehandlung und einer anschliessenden Metallisierbehandlung, wobei die Reinigungsvorbehandlung eine eventuelle Behandlung in einem organischen Lösungsmittel, eine Behandlung in einer Permanganat Alkalilösung sowie eine Behandlung zur Reduktion des Permanganats umfasst und die Metallisierbehandlung eine Behandlung zur Aufbereitung der Wandungen der Durchgangsbohrungen, eine Beizbehandlung der Kupferflächen, eine katalytische Vorbehandlung, eine katalytische Behandlung und eine Metallisierbehandlung in einem chemischen Kupferbad umfasst, dadurch gekennzeichnet, dass drei Behandlungen, und zwar die Reduktion des Permanganats, die Aufbereitung der Durchgangsbohrungen und das Beizen der Kupferflächen, in einem einzigen Vorgang vorgenommen werden, wobei die Behandlung zur Aufbereitung der Durchgangsbohrungen mit wasserlöslichen, nichtoberflächenaktiven Polymeren der Klasse der kationischen Polyelektrolyten in einer Konzentration zwischen 0,001 und 100 g/l erfolgt.

2. Verfahren nach Anspruch 1, dadurch gekennzeichnet, dass die Behandlung zur Reduktion des Permanganats in saurer Umgebung mit Wasserstoffperoxyd vorgenommen wird, das auch auf die Kupferflächen eine oxydierende Wirkung ausübt.

3. Verfahren nach Anspruch 1, dadurch gekennzeichnet, dass die Metallisierbehandlung in einem chemischen Kupferbad vorgenommen wird, bei dem die Quelle der Kupferionen aus einem Salz besteht, das zu der Kupferchloryd, Kupfersulfat, Kupferfluorborat und Kupfernitrat enthaltenden Gruppe gehört.

4. Verfahren nach Anspruch 3, dadurch gekennzeichnet, dass die Metallisierbehandlung in einem chemischen Kupferbad vorgenommen wird, bei dem das zur Kupferkomplexierung verwendete Mittel aus N,N,N′,N′-tetra-(2-hydroxypropyl)-äthylendiamin oder Derivate desselben besteht.

5. Verfahren nach Anspruch 4, dadurch gekennzeichnet, dass die Metallisierbehandlung in einem chemischen Kupferbad vorgenommen wird, das bei einem über 13 liegenden pH-Wert wirkt.

6. Verfahren nach Anspruch 3, dadurch gekennzeichnet, dass die Metallisierbehandlung in einem chemischen Kupferbad vorgenommen wird, bei dem das zur Kupferkomplexierung verwendete Mittel aus Salzen der Aethylendiamin-tetra-essigsäure oder Derivate derselben besteht.

7. Verfahren nach Anspruch 6, dadurch gekennzeichnet, dass die Metallisierbehandlung in einem chemischen Kupferbad vorgenommen wird, das bei einem über 13,5 liegenden pH-Wert wirkt.

8. Verfahren nach Anspruch 1, dadurch gekennzeichnet, dass die Behandlung mit dem organischen Lösungsmittel in einem wasserlöslichen organischen Lösungsmittel vorgenommen wird, das zu der N-methyl-2-pyrrolidon und Dimethylformamid enthaltenden Gruppe gehört.

9. Verfahren nach Anspruch 1, dadurch gekennzeichnet, dass die Behandlung mit dem organischen Lösungsmittel in einer Wasserlösung in alkalischer Umgebung wenigstens eines wasserlöslichen organischen Lösungsmittel vorgenommen wird, das zu der Propylenglykolmonomethyläther und Dipropylenglykolmonomethyläther enthaltenden Gruppe gehört.

10. Verfahren nach Anspruch 1, dadurch gekennzeichnet, dass die Behandlung in einer Permanganat Alkalilösung mit einer Natrium- oder Kaliumpermanganat enthaltenden Lösung vorgenommen wird.

11. Verfahren nach Anspruch 10, dadurch gekennzeichnet, dass die Behandlung in einer Permanganat Alkalilösung mit einer Lösung vorgenommen wird, die Kaliumpermanganat in einer Konzentratrion zwischen 150 g/l und 250 g/l und Natriumhydroxyd in einer Konzentration zwischen 15 g/l und 30 g/l enthält.

12. Verfahren nach Anspruch 10, dadurch gekennzeichnet, dass die Behandlung in einer Permanganat Alkalilösung mit einer Lösung vorgenommen wird, die Kaliumpermanganat in einer Konzentratrion zwischen 40 g/l und 80 g/l und Natriumhydroxyd in einer Konzentration zwischen 30 g/l und 50 g/l enthält.

13. Verfahren nach Anspruch 1, dadurch gekennzeichnet, dass die katalytische Vorbehandlung in einer 200 g/l Natriumchlorid und 20 ml/l 37%iger Chlorwasserstoffsäure enthaltenden Lösung vorgenommen wird.

**14.** Verfahren nach Anspruch 1, dadurch gekennzeichnet, dass die katalytische Vorbehandlung in einer 300 ml/l 37%iger Chlorwasserstoffsäure enthaltenden Lösung vorgenommen wird.

**15.** Verfahren nach Anspruch 1, dadurch gekennzeichnet, dass die katalytische Behandlung in einer sauren Lösung auf Basis von Palladium und Zinnchlorid vorgenommen wird, wobei der Anteil an Palladium zwischen 0,05 g/l und 0,20 g/l und der Anteil an Zinnchlorid zwischen 5 g/l und 20 g/l liegt.

**16.** Verfahren nach Anspruch 1, dadurch gekennzeichnet, dass die katalytische Behandlung in einer Alkalilösung auf Basis von Palladium in ionischer Form vorgenomnen wird.

**17.** Verfahren nach Anspruch 1, dadurch gekennzeichnet, dass die katalytische Behandlung in einer Lösung auf Kupferbasis oder auf Kupfer- und Palladiumbasis vorgenommen wird.

**18.** Verfahren nach Anspruch 1, dadurch gekennzeichnet, dass die katalytische Behandlung in einer Lösung auf Basis eines Edelmetalls, wie etwa Platin, Gold oder Silber, vorgenommen wird.

**19.** Verfahren nach Anspruch 1, dadurch gekennzeichnet, dass es zur Herstellung von doppelseitigen (harten, weichen, biegesteifen) gedruckten Schaltungen zur Anwendung kommt.

**20.** Verfahren nach Anspruch 1, dadurch gekennzeichnet, dass es zur Herstellung von mehrschichtigen (harten, weichen, biegesteifen) gedruckten Schaltungen zur Anwendung kommt.

**21.** Verfahren nach Anspruch 1, dadurch gekennzeichnet, dass die Reinigungs- und Metallisierbehandlung der Durchgangsbohrungen der (doppelseitigen oder mehrschichtigen) gedruckten Schaltungen in einer herkömmlichen Metallisierungsstrasse ohne wesentliche Konstruktionsveränderungen vorgenommen wird.

**22.** Zusammensetzung zur Ausführung von drei Behandlungen in einem einzigen Vorgang bei einem integrierten Reinigungs- und Metallisierverfahren zur Herstellung von gedruckten Schaltungen, dadurch gekennzeichnet, dass sie eine Säure, Wasserstoffperoxyd, ein Stabilisierungsmittel des Wasserstoffperoxyds und ein nichtoberflächenaktives, zur Klasse der kationischen Polyelektrolyten gehörendes Aufbereitungsmittel enthält, das in der Wasserlösung in einer Konzentration zwischen 0,001 g/l und 100 g/l verwendet wird.

**23.** Zusammensetzung nach Anspruch 22, dadurch gekennzeichnet, dass das nichtoberflächenaktive Aufbereitungsmittel aus wenigstens einem abgeänderten kationischen Polymer der Akrylsäure besteht.

**24.** Zusammensetzung nach Anspruch 22, dadurch gekennzeichnet, dass das nichtoberflächenaktive Aufbereitungsmittel aus wenigstens einem Polymer auf Basis eines Esters der Metakrylsäure besteht.

**25.** Zusammensetzung nach Anspruch 24, dadurch gekennzeichnet, dass das Polymer auf Basis eines Esters der Metakrylsäure in einer Konzentration zwischen 0,001 g/l und 100 g/l, vorzugsweise zwischen 0,01 g/l und 5 g/l, verwendet wird.

**26.** Zusammensetzung nach Anspruch 22, dadurch gekennzeichnet, dass das Wasserstoffperoxyd in einer Konzentration zwischen 1 g/l und 100 g/l, vorzugsweise zwischen 10 g/l und 40 g/l, verwendet wird.

**27.** Zusammensetzung nach Anspruch 22, dadurch gekennzeichnet, dass die Säure eine anorganische Säure ist.

**28.** Zusammensetzung nach Anspruch 27, dadurch gekennzeichnet, dass die anorganische Säure Schwefelsäure ist.

**29.** Zusammensetzung nach Anspruch 28, dadurch gekennzeichnet, dass die Schwefelsäure in einer Konzentration zwischen 50 g/l und 200 g/l verwendet wird.

**30.** Zusammensetzung nach Anspruch 27, dadurch gekennzeichnet, dass die anorganische Säure Phosphorsäure ist.

**31.** Zusammensetzung nach Anspruch 30, dadurch gekennzeichnet, dass die Phosphorsäure in einer Konzentration zwischen 100 g/l und 300 g/l verwendet wird.

32. Zusammensetzung nach Anspruch 22, dadurch gekennzeichnet, dass sie ein organisches Stabilisierungsmittel des Wasserstoffperoxyds enthält.

33. Zusammensetzung nach Anspruch 32, dadurch gekennzeichnet, dass das organisches Stabilisierungsmittel aus Para-hydroxybenzoesäure besteht.

34. Zusammensetzung nach Anspruch 33, dadurch gekennzeichnet, dass die Para-hydroxybenzoesäure in einer Konzentration zwischen 0,01 g/l und 100 g/l, vorzugsweise zwischen 0,05 g/l und 0,5 g/l, verwendet wird.

## Claims

1. A process for manufacturing printed circuits including through holes, comprising a cleaning pretreatment and a subsequent metallization treatment, wherein the cleaning pretreatment includes a possible treatment by organic solvent, a treatment in an alcaline solution of permanganate and a treatment for permanganate reduction, and the metallization treatment includes a treatment for conditioning the walls of the through holes, a treatment for mordanting the copper surfaces, a precatalysis treatment, a catalysis treatment and a metallization treatment by a chemical copper bath, characterized in that three treatments, namely reducing the permanganate, conditioning the walls of the through holes and mordanting the copper surfaces, are performed in a single step, the treatment for conditioning the walls of the through holes being performed by means of non-surfactant water soluble polymers, belonging to the group of cationic polyelectrolytes, present in a concentration ranging from 0.001 g/l and 100 g/l.

2. A process as set forth in Claim 1, characterized in that the treatment for reducing the permanganate is performed by means of hydrogen peroxide in acid ambient, which also acts as oxidizer with respect to the copper surfaces.

3. A process as set forth in Claim 1, characterized in that the metallization treatment is performed in a chemical copper bath wherein the source of copper ions consists of a copper salt belonging to the group comprising copper chloride, copper sulfate, copper fluoborate and copper nitrate.

4. A process as set forth in Claim 3, characterized in that the metallization treatment is performed in a chemical copper bath wherein the copper complexing agent consists of N,N,N′,N′ tetra(2-hydroxypropyl)-ethylenediamine, or a derivative thereof.

5. A process as set forth in Claim 4, characterized in that the metallization treatment is performed in a chemical copper bath which operates at a pH over 13.

6. A process as set forth in Claim 3, characterized in that the metallization treatment is performed in a chemical copper bath wherein the copper complexing agent consists of salts of the ethylenediaminetetraacetic acid, or derivatives thereof.

7. A process as set forth in Claim 6, characterized in that the metallization treatment is performed in a chemical copper bath which operates at a pH over 13.5.

8. A process as set forth in Claim 1, characterized in that the treatment in an organic solvent is performed in a water soluble organic solvent belonging to the group comprising N-methyl-2-pyrrolidone and dimethylformamide.

9. A process as set forth in Claim 1, characterized in that the treatment in an organic solvent is performed in an aqueous solution in alcaline ambient of at least one water soluble organic solvent belonging to the group comprising propylenglycolmonomethylether and dipropylenglycolmonomethylether.

10. A process as set forth in Claim 1, characterized in that the treatment in an alcaline permanganate solution is performed in a solution containing sodium permanganate or potassium permanganate.

11. A process as set forth in Claim 10, characterized in that the treatment in an alcaline permanganate solution is performed in a solution containing potassium permanganate in a concentration ranging between 150 g/l and 250 g/l, and sodium hydroxide in a concentration ranging between 15 g/l and 30 g/l.

**12.** A process as set forth in Claim 10, characterized in that the treatment in an alcaline permanganate solution is performed in a solution containing potassium permanganate in a concentration ranging between 40 g/l and 80 g/l, and sodium hydroxide in a concentration ranging between 30 g/l and 50 g/l.

**13.** A process as set forth in Claim 1, characterized in that the precatalysis treatment is performed in a solution containing 200 g/l of sodium chloride and 20 ml/l of 37 % hydrochloric acid.

**14.** A process as set forth in Claim 1, characterized in that the precatalysis treatment is performed in a solution containing 300 ml/l of 37 % hydrochloric acid.

**15.** A process as set forth in Claim 1, characterized in that the catalysis treatment is performed in an acid solution based on palladium and tin chloride, with contents of palladium ranging between 0.05 g/l and 0.20 g/l and contents of tin chloride ranging between 5 g/l and 20 g/l .

**16.** A process as set forth in Claim 1, characterized in that the catalysis treatment is performed in an alcaline solution based on palladium under ionic form.

**17.** A process as set forth in Claim 1, characterized in that the catalysis treatment is performed in a solution based on copper or copper and palladium.

**18.** A process as set forth in Claim 1, characterized in that the catalysis treatment is performed in a solution based on a noble metal such as platinum, gold or silver.

**19.** A process as set forth in Claim 1, characterized in that it is used for manufacturing double face (rigid, flexible or flexirigid) printed circuits.

**20.** A process as set forth in Claim 1, characterized in that it is used for manufacturing multilayer (rigid, flexible or flexirigid) printed circuits.

**21.** A process as set forth in Claim 1, characterized in that the treatment for cleaning and metallizing the through holes of printed circuits (double face or multilayer) is performed in a conventional metallization line, without any substantial modification of its structure.

**22.** A composition intended to perform three treatments in a single step within an integrated cleaning and metallization process for the manufacture of printed circuits, characterized in that it contains an acid, hydrogen peroxide, a stabilizer for the hydrogen peroxide and a non-surfactant conditioning product belonging to the group of the cationic polyelectrolytes.

**23.** A composition as set forth in Claim 22, characterized in that said non-surfactant conditioning product is formed by at least one cationic modified polymer of the acrylic acid.

**24.** A composition as set forth in Claim 22, characterized in that said non-surfactant conditioning product is formed by a polymer based on an esther of the methacrylic acid.

**25.** A composition as set forth in Claim 24, characterized in that the polymer based on an esther of the methacrylic acid is present in a concentration ranging between 0.001 g/l and 100 g/l and preferably ranging between 0.01 g/l and 5 g/l.

**26.** A composition as set forth in Claim 22, characterized in that the hydrogen peroxide is present in a concentration ranging between 1 g/l and 100 g/l, and preferably ranging between 10 g/l and 40 g/l,

**27.** A composition as set forth in Claim 22, characterized in that said acid is an inorganic acid.

**28.** A composition as set forth in Claim 27, characterized in that said inorganic acid is sulfuric acid.

**29.** A composition as set forth in Claim 28, characterized in that the sulfuric acid is present in a concentration ranging between 50 g/l and 200 g/l.

**30.** A composition as set forth in Claim 27, characterized in that said inorganic acid is phosphoric acid.

**31.** A composition as set forth in Claim 30, characterized in that the phosphoric acid is present in a concentration ranging between 100 g/l and 300 g/l.

**32.** A composition as set forth in Claim 22, characterized in that it comprises an organic stabilizer of the hydrogen peroxide.

**33.** A composition as set forth in Claim 32, characterized in that said organic stabilizer is formed by para-hydroxybenzoic acid.

**34.** A composition as set forth in Claim 33, characterized in that the para-hydroxybenzoic acid is present in a concentration ranging between 0.01 g/l and 100 g/l, and preferably ranging between 0.05 g/l and 0.5 g/l.